# EUROPÄISCHE PATENTSCHRIFT

(11) **EP 0 464 273 B1**
(45) Veröffentlichungstag und Bekanntmachung des Hinweises auf die Patenterteilung: **21.02.1996**
(21) Anmeldenummer: 90203539.3
(22) Anmeldetag: 20.08.1990
(51) Int. Cl.: H03G 3/00, H04R 3/00

(54) **Elektro-akustisches Gerät**
Electro-acoustic device
Appareil électro-acoustique

(30) Priorität: 24.08.1989 DE 3927902
(43) Veröffentlichungstag der Anmeldung: 08.01.1992
(73) Patentinhaber: Deutsche Thomson-Brandt GmbH, D-78003 Villingen-Schwenningen (DE)
(72) Erfinder: Lavaud, Simon-André, D-7730 Villingen-Schwenningen (DE)

(56) Entgegenhaltungen:
- EP-A- 0 171 524
- EP-A- 0 323 102
- DE-A- 3 722 752
- PATENT ABSTRACTS OF JAPAN vol. 10, no. 275 (E-438)18. September 1986 & JP-A-61 098 007 ( MATSUSHITA ) 16. Mai 1986

## Beschreibung

Die Erfindung betrifft ein elektroakustisches Gerät mit einer Anordnung zur Wiedergabe von Sprache und/oder Musik und einer Anordnung zur Einstellung der Lautstärke der wiedergegebenen Signale.

Geräte dieser Art sind z.B. aus E. Zwicker & M. Zollner: Elektrotechnik; Springer Verlag, Berlin, 1984, Seite 116 bekannt. Hier werden Beschallungsanlagen für größere Räume beschrieben, bei denen zur Wahrnehmung von Übersteuerungen Begrenzer (Limiter) eingesetzt werden. Diese besitzen zur Einstellung des Begrenzungseinsatzes einen Steller. mit dem die maximal mit ihnen erzielbare Lautstärke verändert werden kann. Außerdem besitzen sie den eigentlichen Lautstärkesteller, mit dem die Lautstärke bis zum Einsatz des Limiters vom Anwender geregelt werden kann.

Aus der DE-A- 37 22 752 ist eine Einrichtung zur Einstellung, Speicherung und zum Abruf von Einstellgrößen an elektroakustischen Geräten bekannt, die einen Mikroprozessor zur Betätigung dieser Funktionen nutzt.

Die eingangs genannten Geräte, die zur Wiedergabe akustischer Signale dienen, sind oftmals so groß dimensioniert, daß sie bei einer Fehlbedienung entweder die elektroakustischen Wandler zerstören können oder durch einen zu hohen Wiedergabepegel störend auf die Umwelt einwirken oder sogar Personen gesundheitlich schädigen können.

Es ist deshalb Aufgabe der Erfindung, ein elektroakustisches Gerät anzugeben, das diese Fälle vermeidet. Diese Aufgabe wird durch die im Patentanspruch 1 angegebene Maßnahme gelöst. Der Patentanspruch 2 gibt eine vorteilhafte Ausgestaltung der Erfindung an.

Es ist bekannt, die Einstellung z.B. der Lautstärke digital vorzunehmen, wonach über entsprechende Digital-Analog-Wandler die analoge Einstellung erfolgt. Die Erfindung sieht vor, daß ein Speicher vorgesehen ist, in welchem ein Wert abspeicherbar ist, der einem gewünschten Wiedergabepegel entspricht, welcher vom Benutzer des Gerätes durch seine Einstellung nicht überschritten werden kann. Dieser maximale Wert ist individuell voreinstellbar und kann den gegebenen äußeren Umständen angepaßt werden, indem entweder auf die angeschlossenen elektroakustischen Wandler oder auf physiologische Belastungen Rücksicht genommen wird. Ein Überschreiben dieses maximalen Wertes wird durch eine dafür vorgesehene Sondertaste ermöglicht.

Die Erfindung eignet sich insbesondere für mikroprozessorgesteuerte Geräte, da sie keine zusätzliche Kosten verursacht, weil sie in die Software des Gerätes mitaufgenommen werden kann.

Nachstehend wird die Erfindung an einem Ausführungsbeispiel mit Hilfe der Zeichnung beschrieben.
- Fig. 1: zeigt einen Plan eines in dem Gerät ablaufenden Programms,
- Fig. 2: zeigt ein Blockschaltbild zur Erläuterung der Wirkungsweise

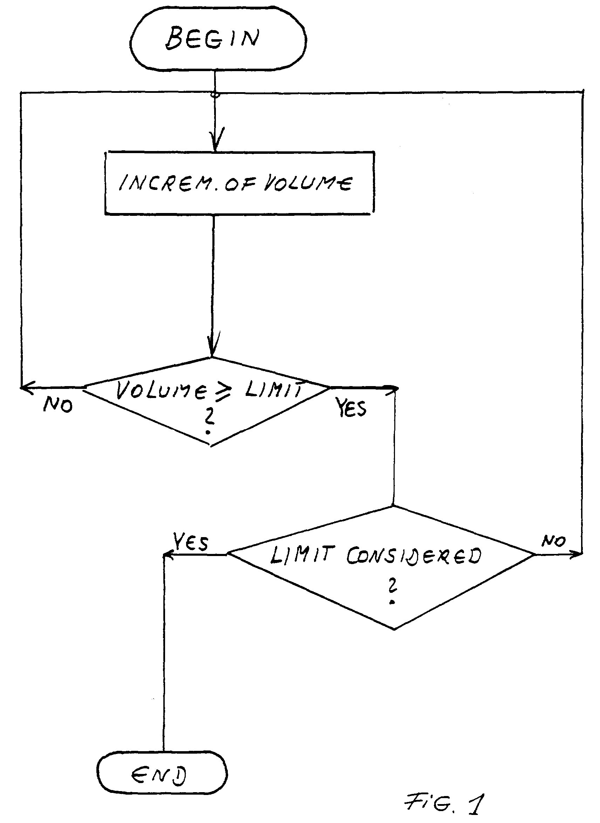

In Fig. 1 ist der Ablaufplan eines Programms aufgezeichnet, nach welchem das elektroakustische Gerät arbeitet und welches durch einen Mikroprozessor ausgeführt wird.

Bei der Verstellung der Lautstärke durch einen Impulsgeber wird die Lautstärke schrittweise verändert. Bei einer schrittweisen Erhöhung dieser Lautstärke wird laufend geprüft, ob der momentan eingestellte Wert größer oder gleich einem zuvor abgespeicherter Grenzwert ist. Erst bei Erreichen des Grenzwertes wird die weitere Erhöhung der Lautstärke verhindert und es bleibt trotz Betätigung des Stellgliedes bei der erreichten Lautstärke. In einer zusätzlichen Abfrage wird noch entschieden, ob der Grenzwert überschritten werden darf oder nicht. Im Fall "Ja" wird die Lautstärkeerhöhung trotz erreichtem Grenzwert vorgenommen. Zum Beispiel kann es vorkommen, daß man den abgespeicherten Wert doch überschreiten möchte. Dies ist jedoch nur möglich, indem durch Betätigen einer Sondertaste diese Erhöhung durchgeführt werden kann. So kann z.B. erreicht werden, daß Unbefugte wie Kinder die Lautstärke nur bis zum eingestellten Grenzwert verändert können, daß aber ein Erwachsener nach Betätigen einer nur ihm bekannten Taste die weitergehende Einstellung der Lautstärke vornehmen kann.

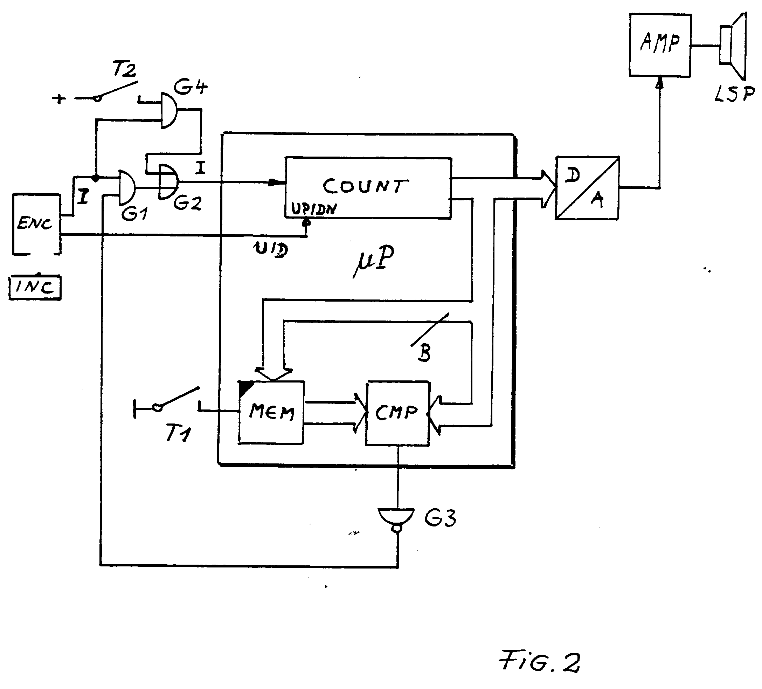

In Figur 2 werden die soeben beschriebenen Vorgänge am Beispiel eines Blockschaltbildes erläutert.

Es wird zunächst angenommen, daß die eingestellte Lautstärke auf Minimum steht. Durch Betätigen eines Inkrementalgebers INC in Form eines Drehknopfes werden Impulse I abgegeben, die in einem Encoder ENC ausgewertet werden, indem dieser die Impulse ausgibt und gleichzeitig über eine Leitung U/D (UP/DOWN) einen Binärzähler COUNT auf- oder abwärts zählen läßt. Die Impulse I gelangen über ein AND-Gatter G1 und ein OR-Gatter G2 an den Zähleingang des Zählers COUNT. Das AND-Gatter G1 ist zunächst durch den H-Pegel aus dem Gatter G3 durchlässig. Bei Erreichen einer bestimmten Lautstärke, d.h. bei Erreichen eines Zählerstandes des Zählers, der dem gewünschten Grenzwert entspricht, kann dieser durch Betätigen einer Taste T1 in einem Speicher MEM abgespeichert werden. Der vom Zähler ausgegebene Wert wird über eine BUS-Leitung B an einen Digital-Analog-Wandler D/A geleitet, dessen analoge Ausgangsspannung als Steuerspannung für einen Verstärker AMP dient, an den ein Lautsprecher LSP angeschlossen ist.

Bei einer späteren Verstellung der Lautstärke wird dauernd der vom Zähler erzeugte digitale Wert mit dem abgespeicherten Wert in einem Komparator CMP verglichen. Bei Gleichheit wird ein H-Pegel ausgegeben, der durch das Gatter G3 negiert wird, wodurch durch das AND-Gatter G1 gesperrt wird, so daß keine weiteren Impulse I aus dem Encoder mehr durchgelassen werden, d.h. aber auch, daß der Zählerstand stehen bleibt und nicht weiter erhöht werden kann, selbst wenn der Inkrementalgeber betätigt wird.

Sollte jedoch trotzdem einmal dieser Wert überschritten werden können, was nur durch eine autorisierte Person möglich sein soll, kann durch Betätigen einer speziellen, nicht ohne weiteres zugänglichen Code-Taste T2 ein Gatter G4 geöffnet werden, welches die Impulse I an den Zähleingang des Zählers durchschaltet.

## Patentansprüche

1. Elektroakustisches Gerät mit einer Anordnung (AMP, LSP) zur Wiedergabe von Sprache und/oder Musik und einer Anordnung zur Einstellung der Lautstärke der wiedergegebenen Signale, **dadurch gekennzeichnet**, daß die Einstellung über einen Mikroprozessor derart erfolgt, daß der Maximalwert der einstellbaren Lautstärke veränderbar und abspeichbar (T1) ist, und daß ein Überschreiten des maximalen Wertes durch eine dafür vorgesehene Sondertaste (T2) ermöglicht ist.

2. Gerät nach Anspruch 1, **dadurch gekennzeichnet**, daß der maximale Wert die angeschlossenen elektroakustischen Wandler (LSP) oder physiologische Belastungen durch Lautstärke berücksichtigend angepaßt ist.

## Claims

1. An electro-acoustic device with an arrangement (AMP, LSP) for the reproduction of speech and/or music and with an arrangement for setting the volume of the reproduced signals, characterised in that the setting takes place via a microprocessor in such manner that the maximum value of the adjustable volume can be changed and stored (T1), and that overshooting of the maximum value is facilitated by a special key (T2) provided for this purpose.

2. A device as claimed in Claim 1, characterised in that the maximum value is adjusted taking into consideration the connected electro-acoustic transducers (LSP) or physiological stresses caused by sound intensity.

## Revendications

1. Appareil électro-acoustique comportant un dispositif (AMP, LSP) pour la reproduction vocale et/ou musicale, et un dispositif pour le réglage de l'intensité sonore des signaux reproduits, **caractérisé en ce** que le réglage est assuré par l'intermédiaire d'un microprocesseur de telle manière que la valeur maximale du volume réglable puisse être modifiée et mémorisée (T1) et que le dépassement de ladite valeur maximale soit possible au moyen d'une touche spéciale (T2) prévue à cet effet.

2. Appareil selon la revendication 1 **caractérisé en ce** que ladite valeur maximale permet de ménager les transducteurs électro-acoustiques (LSP) connectés et de prévenir les troubles physiologiques provoquées par l'intensité sonore.
